# EUROPEAN PATENT APPLICATION

(11) **EP 0 629 785 A2**
(43) Date of publication of application: **21.12.1994**
(21) Application number: 94303931.3
(22) Date of filing: 01.06.1994
(51) Int. Cl.: F16B 5/02, F16B 5/04, B29C 65/60, H05K 7/14

(54) **Mounting components in plastic casings**

(30) Priority: 01.06.1993 JP 130164/93; 23.06.1993 JP 152153/93
(71) Applicant: TOHOKU MUNEKATA Co., Ltd., Fukushima-shi, Fukushima-Ken (JP)
(72) Inventor: Shigihara, Kiyoshi, c/o Tohoku Munekata Co., Ltd., Fukushima-shi, Fukushima-ken (JP)
(74) Representative: King, James Bertram

(57) **Abstract**

A substrate (15) is secured to a casing (10) by means of a boss (11) having a shouldered base (12) and a smaller diameter spigot (13) with a tip (13a) provided with a blind hole (14) and passing through aperture (16). Initial fixing is achieved by using a heated die (17) which melts and deforms tip (13a) into a head (18). For dismounting substrate (15) head (18) is cut-off. For remounting a self-tapping screw can be threaded into hole (14).

## Description

This invention relates to a method and a means for mounting a component or substrate to a base member being a plastic moulded product.

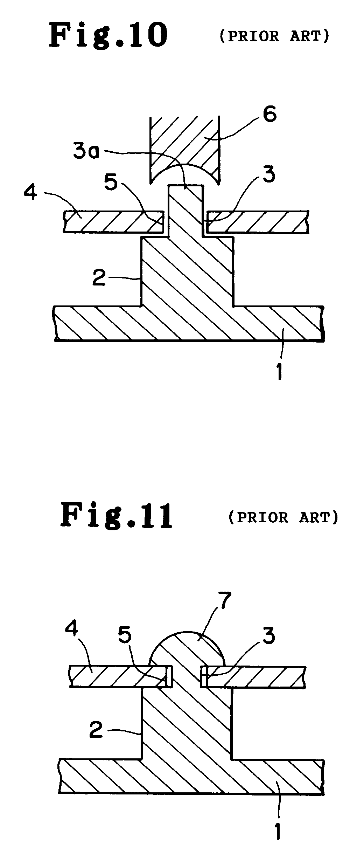

Figure 10 and Figure 11 of the accompanying drawings show a typical prior art example of a method for mounting a component or substrate to a plastic moulded product. The method involves forming, by moulding, a head 7 to secure a component or substrate 4 to a boss 2. The boss 2 is provided in advance with a small diameter spigot portion 3 formed on the top side. The boss 2 is connected at one side of a plastic moulded product 1 during the moulding process and may be integral therewith. A mounting hole 5 is provided in the side of the component or substrate 4 into which the small diameter spigot 3 of the boss 2 locates. Heat for fusing the spigot 3 from the tip 3a is applied using a fusion die 6 for pressing and collapsing the spigot 3 at the same time.

However, if the tip 3a of the spigot is pressed and collapsed as described above to achieve fixing then when the head 7 is cut off for dismounting the component or the substrate 4 or for replacing the part, the spigot cannot be melted and used again to fix the component to the boss in the same manner utilising the mounting hole 5.

Therefore, a prior art method has been adopted wherein a separate member of the same diameter is joined to the part of the spigot 3 remaining on the boss 2 and the spigot 3 is formed again after cutting off the spigot of the boss 2. This allows mounting of the component or substrate 4 in the same way as the first method. However, this method involves considerable work and cannot be carried out with ease.

One of the objects of this invention is to provide a method wherein the component or the substrate can be secured again easily to the boss on a moulded product after dismounting.

A further object of this invention is to provide a method whereby a component or a substrate can be easily secured to a boss on a moulded product during an original manufacturing procedure and wherein the connection can be broken (if the substrate or moulded part is damaged) and wherein a new part can be connected using the same boss on the moulded product.

According to this invention there is provided a method of securing a component or substrate to a plastic product, the component or substrate having a mounting hole and the plastic product having a boss with a smaller diameter spigot formed on an upper end, the spigot being positioned in the said mounting hole of said component or substrate with the tip protruding from an upper surface of said component or substrate, the tip being deformed by heat and pressure to form a head portion having a diameter greater than said mounting hole to secure the component or substrate against a shouldered portion of the boss, characterised by the boss including an axial hole extending at least in part into said head portion.

In a preferred arrangement the method of the invention provides a means for securing the component or substrate after release by cutting-off the head portion, this being achieved by utilising the axial hole into which a self-tapping screw may be inserted to mount the component or substrate onto the remaining part of the spigot.

For a better understanding of the invention and operating advantages and specific objects attained in use, reference is now made to the accompanying drawings and description relating to preferred embodiments shown by way of examples of the invention.

In the drawings:
- Figure 1: shows an example for fixing a part to a boss in which a screw receiving hole has been provided,
- Figure 2: shows the part fixed to the boss,
- Figure 3: shows the head which secures the part being cut off and the hole being exposed,
- Figure 4: shows the part fixed by a screw,
- Figure 5: shows an example for fixing the part to the boss where a screw receiving hole has been provided from the opposite side of the boss,
- Figure 6: shows a part being fixed to the boss of Figure 5,
- Figure 7: shows the head of the boss shown in Figure 6 being cut off and the hole being exposed,
- Figure 8: shows the part being fixed by a screw utilising the hole that has been exposed in Figure 7,
- Figure 9: is an explanatory drawing of a heated fusion die press,
- Figure 10: shows schematically an example of a fusion due for pressing and collapsing the spigot of the boss for securing the part and which is a conventional method according to the prior art, and
- Figure 11: shows the secured parts according to the prior art.

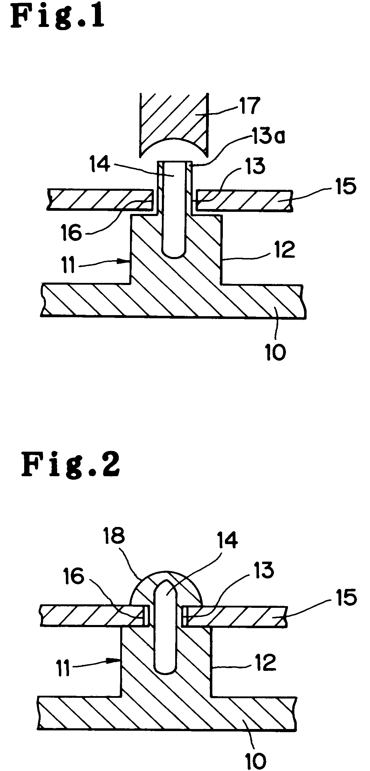

One preferred embodiment of the present invention is described in detail below in conjunction with Figures 1 to 4 of the drawings.

In the drawings a case 10 has an integrally moulded boss 11 having a large diameter portion 12 and a small diameter spigot 13 moulded on the upper end with a hole 14 being formed through the centre.

A substrate 15 of a component has a mounting hold 14 being formed through the centre.

A substrate 15 of a component has a mounting hole 16 into which the spigot 13 fits. When mounting the substrate on the boss the mounting hole 16 is located over the spigot and rests against the shoulder of boss 11. The tip 13a of the spigot 13 protrudes through the mounting hole 16 and is softened and melted to enable same to be pressed to collapse as shown in Figure 2 using a fusion die press 17 and a head 18 is formed to secure the parts together.

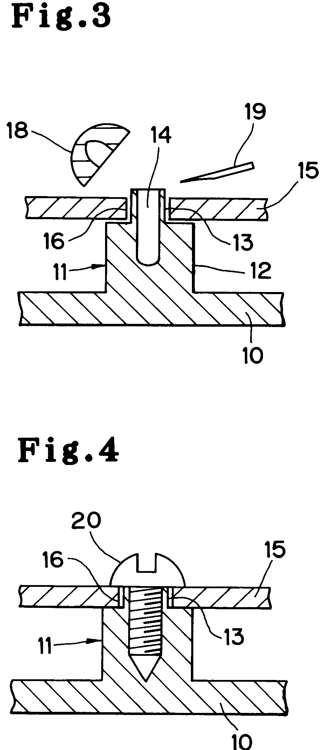

When dismounting the substrate 15 from the boss which has been fixed as described above, the portion of head 18 is cut off using a cutter 19 as shown in Figure 3. By doing so, the mounting hole 16 of substrate 15 can be dismounted easily from the spigot 13.

When mounting the substrate again, the mounting hole 16 of substrate 15 is again fitted over the remaining part of the spigot 13 and secured using a self-tapping screw 20. Thereafter, the substrate 15 can be fixed and dismounted as many times as required by removing the screw.

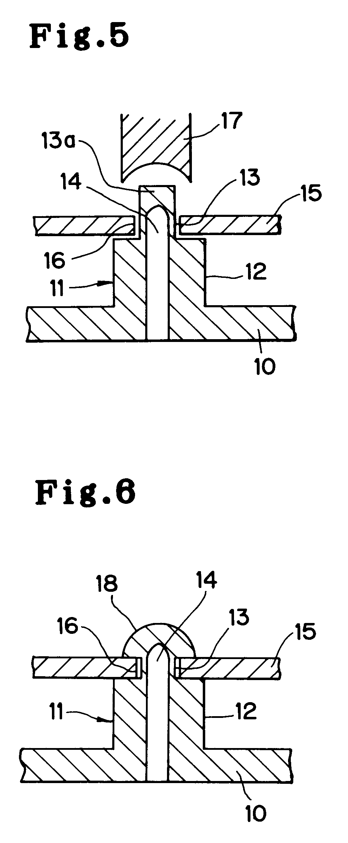

The second embodiment according to this invention is further described with reference to Figures 5 to 8.

As shown a casing 10 is provided with an integrally moulded boss 11 having a large diameter part 12 and a small diameter spigot 13 formed on the upper end and a hole 14 formed in the centre which extends inside the spigot 13 from the other side of casing 10. The hole 14 may also be provided through the boss 11.

A substrate part 15 has a mounting hole 16 through which the small diameter spigot 13 passes. When mounting the substrate, this mounting hole 16 is located over the spigot 13. The top 13a of the spigot 13 protrudes through the mounting hole 16 and is pressed to collapse same using a fusion die 17 in order to form a head 18 for securing against the boss as shown in Figure 6.

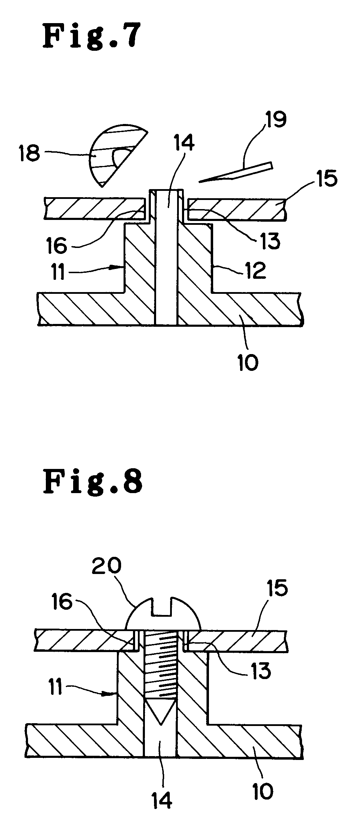

When dismounting the substrate 15 from the boss 11 that has been secured as described above, the head portion 18 is cut off using a knife 19 as shown in Figure 7. By doing so, the mounting hole 16 of substrate 15 can be disengaged easily from the spigot 13 and at the same time the hole 14 can be exposed at the cut portion.

When mounting the substrate 15 again, the mounting hole 16 of the substrate 15 is fitted over the remaining spigot 13, and the self-tapping screw 20 is screwed into the vertical hole 14 exposed by the cut end, thereby to secure the substrate 15. Thereafter, the substrate 15 can be secured or dismounted as many times as required by removing the self-tapping screw 20.

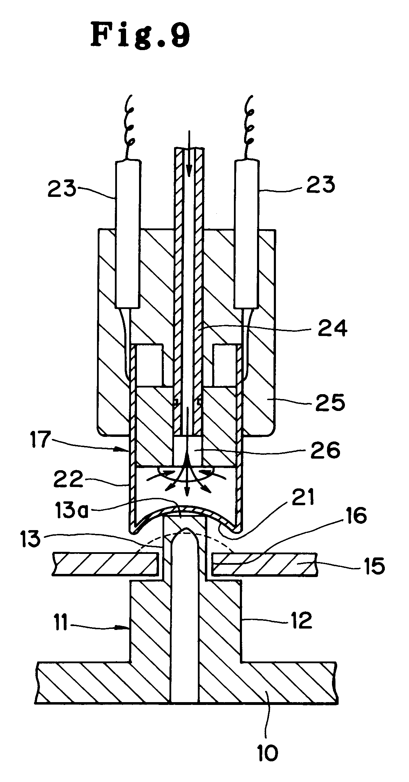

Figure 9 shows an example of fusion die or press 17. This press 17 has a heating element 22 having at one end a pressure contact face 21 for contacting the tip 13a of the spigot to heat and fuse same. A pair of leads 23 are electrically connected to each end of a heating element 22 to provide electricity to heat the heating element. A nozzle 24 is located inside the heating element 22 from the other end and provides an air jet into the heating element part 22 to cool same. A support member 25, 25' is provided for securing the nozzle 24 and the leads 23 in the required position against the heating element 22 and for exhausting air to the outside from the nozzle 24 after having cooled down the heating element 22.

When heating and deforming the tip 13a of the spigot the heating element 22 is heated by electric current from the leads 23. The tip 13a of the spigot 13 is deformed by the pressure exerted through the heating element 22. For cooling down the head 20 of the spigot 13a the power is switched off and cooling air is passed from the nozzle 24, and the deformed head 20 is cooled down via the cooling applied to the heating element 22. When the deforming process is operated again the air jet from the nozzle 24 is stopped and electric power re-applied through leads 23.

Because the component or the substrate can be fixed using the vertical hole and a self-tapping screw even after attaching the component or the substrate to the boss by a heat deforming process, the substrate can be removed, replaced and secured again.

This allows initial assembly to be simplified by providing for many fixings to be deformed at the same time whilst still allowing for subsequent replacement as many times as necessary.

## Claims

1. A method of securing a component or substrate (15) to a plastic product (10), the component or substrate (15) having a mounting hole (16) and the plastic product (10) having a boss (11) with a smaller diameter spigot (13) formed on an upper end, the spigot (13) being positioned in the said mounting hole (16) of said component or substrate (15) with the tip (13a) protruding from an upper surface of said component or substrate (15), the tip being deformed by heat and pressure to form a head portion (18) having a diameter greater than said mounting hole (16) to secure the component or substrate (15) against a shouldered portion of the boss, characterised by the boss (11) including an axial hole (14) extending at least in part into said head portion (18).

2. A method according to Claim 1 and for replacing or remounting the component or substrate (15), characterised by cutting off said head portion (18) to release said component or substrate (15) from said boss (11) and remounting said component or substrate (15) by positioning the remaining portion of the spigot (13) in said mounting hole (16) and screwing a self-tapping screw (20) into said axial hole (14) to secure said component or substrate (15) to said boss (11).

3. A method according to Claim 1 or 2, characterised by the said hole (14) being a blind hole extending from the tip (13a) of the spigot (13) into the boss (11).

4. A method according to Claim 1 or 2, characterised by the said hole (14) being a blind hole extending up through the boss (11) and terminating adjacent the tip (13a) of the spigot (13).

5. A method according to Claim 1 or 2, characterised by the said hole (14) extending through the boss (11) and spigot (13).
